(19)

Europäisches
Patentamt
European
Patent Office
Office européen
des brevets

(11) **EP 3 438 799 A1**

(12) **EUROPEAN PATENT APPLICATION**
published in accordance with Art. 153(4) EPC

(43) Date of publication:
06.02.2019 Bulletin 2019/06

(21) Application number: 17774045.3

(22) Date of filing: 02.03.2017

(51) Int Cl.:
*G06F 3/041* (2006.01)   *G06F 3/044* (2006.01)
*H05K 1/02* (2006.01)   *H05K 3/38* (2006.01)

(86) International application number:
**PCT/JP2017/008330**

(87) International publication number:
**WO 2017/169500 (05.10.2017 Gazette 2017/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: 29.03.2016 JP 2016065920

(71) Applicant: **Fujikura, Ltd.**
**Tokyo 135-8512 (JP)**

(72) Inventor: **SHIOJIRI, Takeshi**
**Sakura-shi**
**Chiba 285-8550 (JP)**

(74) Representative: **Ter Meer Steinmeister & Partner**
**Patentanwälte mbB**
**Artur-Ladebeck-Strasse 51**
**33617 Bielefeld (DE)**

(54) **WIRING BODY, WIRING SUBSTRATE, TOUCH SENSOR AND METHOD FOR PRODUCING WIRING BODY**

(57) A wiring body (5) includes: a main body portion (6) including a first layered portion (7) including a first resin portion (71), and a first conductor portion (72) disposed on the first resin portion, and a second layered portion (8) including a second resin portion (81), and a second conductor portion (82) disposed on the second resin portion; and an overcoat portion (9) disposed on the main body portion to cover the second conductor portion (82), in which surface roughness of a first main surface (61) of the main body portion (6) is relatively greater than surface roughness of a second main surface (91) of the overcoat portion (9), the first main surface (61) is on a side opposite to the overcoat portion (9), the second main surface (91) is on a side opposite to the main body portion (6).

FIG. 3

EP 3 438 799 A1

## Description

TECHNICAL FIELD

The present invention relates to a wiring body, a wiring board, a touch sensor, and a manufacturing method of a wiring body.

For designated countries that are permitted to be incorporated by reference in the literature, the contents of Patent Application No. 2016-065920, filed with Japan Patent Office on March 29, 2016 is incorporated herein by reference and is regarded as a part of the description of this specification.

BACKGROUND ART

It is known that a touch panel sensor including a underlayer, a conductive pattern disposed on the underlayer, and an insulating layer disposed on the underlayer to cover a plurality of conductive patterns is disposed on one side of a film substrate to be releasable (for example, refer to Patent Document 1). In the related art, the touch panel sensor adheres to a target such as a display device through an adhesive layer, and then, the film substrate is released, and thus, the touch panel sensor is transferred onto the target.

CITATION LIST

PATENT DOCUMENT

Patent Document 1: JP 2015-108958 A

SUMMARY OF THE INVENTION

PROBLEM TO BE SOLVED BY THE INVENTION

In general, scattering of light or the like is suppressed by smoothing a surface of the touch panel sensor, and thus, visibility of the touch panel sensor is improved. However, in a case where the touch panel sensor is transferred onto the target by using the related art, an adhering force between the target and the touch panel sensor decreases at the time of performing smoothing up to the surface of the touch panel sensor on a side facing the target, and there is a concern that the touch panel sensor after being transferred is accidentally peeled off from the target.

An object of the present invention is to provide a wiring body, a wiring board, a touch sensor, and a manufacturing method of a wiring body, which are capable of improving the adhering force with respect to the mounting target, and of improving the visibility.

MEANS FOR SOLVING PROBLEM

[1] A wiring body according to the present invention is a wiring body including: a main body portion including at least one layered portion which includes a resin portion, and a conductor portion disposed on the resin portion; and an overcoat portion disposed on the main body portion to cover the conductor portion, in which surface roughness of a first main surface of the main body portion is relatively greater than surface roughness of a second main surface of the overcoat portion, the first main surface is on a side opposite to the overcoat portion, the second main surface is on a side opposite to the main body portion.

[2] In the wiring body according to the present invention described above, the surface roughness of the first main surface may be 10 nm to 100 nm.

[3] In the wiring body according to the present invention described above, the surface roughness of the second main surface may be less than or equal to 5 nm.

[4] In the wiring body according to the present invention described above, the conductor portion may be in a tapered shape in which the conductor portion is narrowed as being close to the overcoat portion.

[5] In the wiring body according to the present invention described above, the main body portion may include two layered portions, the resin portion of one layered portion may be disposed to cover the conductor portion of other layered portion, and may be interposed between the conductor portion of the one layered portion and the conductor portion of the other layered portion, and the overcoat portion may cover the conductor portion of the one layered portion.

[6] In the wiring body according to the present invention described above, the conductor portion may include: a contact surface in contact with the resin portion; and a top surface on a side opposite to the contact surface, the contact surface may be positioned on the same side as the first main surface with respect to the top surface, the top surface may be positioned on the same side as the second main surface with respect to the contact surface, and, surface roughness of the contact surface may be relatively greater than surface roughness of the top surface.

[7] In the wiring body according to the present invention described above, the surface roughness of the contact surface may be relatively greater than the surface roughness of the first main surface, and the surface roughness of the top surface may be relatively greater than the surface roughness of the second main surface.

[8] A wiring board according to the present invention is a wiring board, including: the wiring body described above; a support body supporting the wiring body from a side of the first main surface; and an adhesive portion interposed between the wiring body and the support body.

[9] A touch sensor according to the present invention is a touch sensor, including: the wiring board described above.

[10] A manufacturing method of a wiring body according to the present invention is a manufacturing method of a wiring body including: a first step of curing a conductive material filling a concave portion of an intaglio; a second step of pressing a first board against the engraved plate through a first resin material; a third step of curing the first resin material; a fourth step of integrally releasing an intermediate containing the conductive material and the first resin material, and the first substrate, from the intaglio; a fifth step of pressing a second substrate against the intermediate from a side opposite to the first substrate in the intermediate through a second resin material; a sixth step of curing the second resin material; and a seventh step of releasing the first substrate from the intermediate and of releasing the second substrate from the second resin material, in which surface roughness of a third main surface is relatively greater than surface roughness of a fourth main surface, the third main surface is on a side facing the intermediate, and the fourth main surface is on a side facing the second resin material.

EFFECT OF THE INVENTION

According to the present invention, the surface roughness of the first main surface of the main body portion is relatively greater than the surface roughness of the second main surface of the overcoat portion. In this case, the wiring body is mounted on the target in a state where the first main surface faces the target, and thus, it is possible to improve the adhering force between the wiring body and the target. On the other hand, scattering of light or the like is suppressed on the second main surface, and thus, it is possible to improve the visibility of the wiring body.

BRIEF DESCRIPTION OF DRAWINGS

Fig. 1 is a plan view illustrating a touch sensor in one embodiment of the present invention;
Fig. 2 is an exploded perspective view illustrating a wiring board in one embodiment of the present invention;
Fig. 3 is a cross-sectional view along line III-III of Fig. 1;
Fig. 4 is a cross-sectional view along line IV-IV of Fig. 1;
Fig. 5 is a cross-sectional view for illustrating a first conductor portion in one embodiment of the present invention;
Fig. 6(A) to Fig. 6(E) are (first) cross-sectional views for illustrating a manufacturing method of a wiring body in one embodiment of the present invention;

and
Fig. 7(A) to Fig. 7(H) are (second) cross-sectional views for illustrating the manufacturing method of the wiring body in one embodiment of the present invention.

MODE(S) FOR CARRYING OUT THE INVENTION

Hereinafter, an embodiment of the present invention will be described on the basis of the drawings.

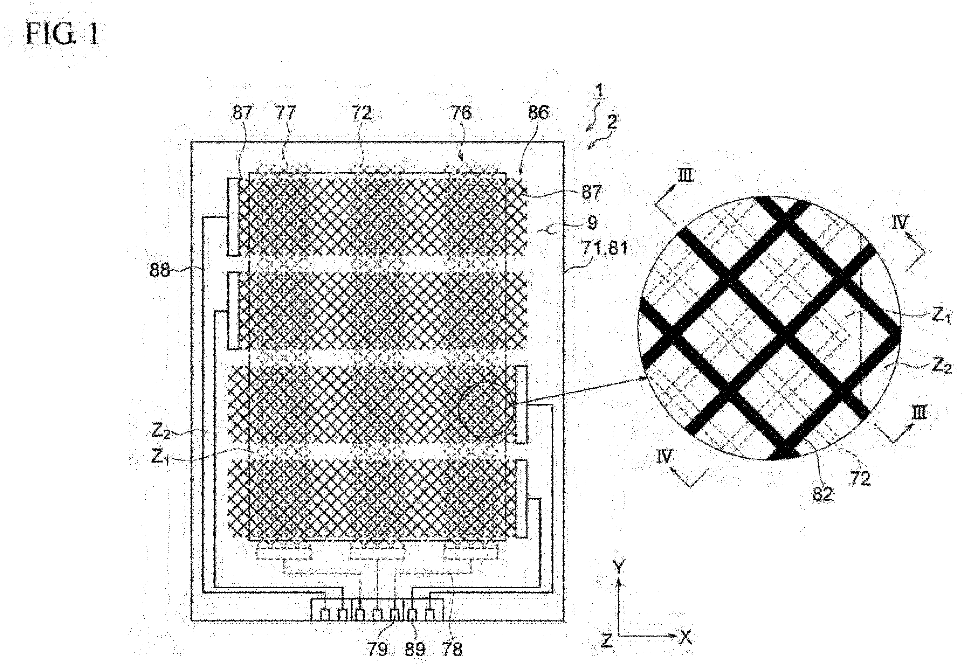

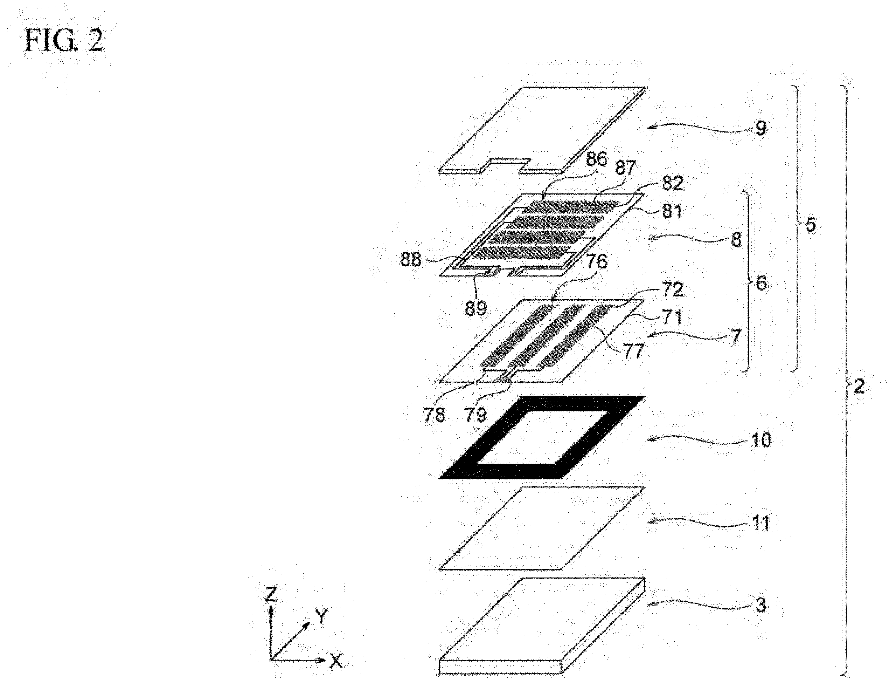

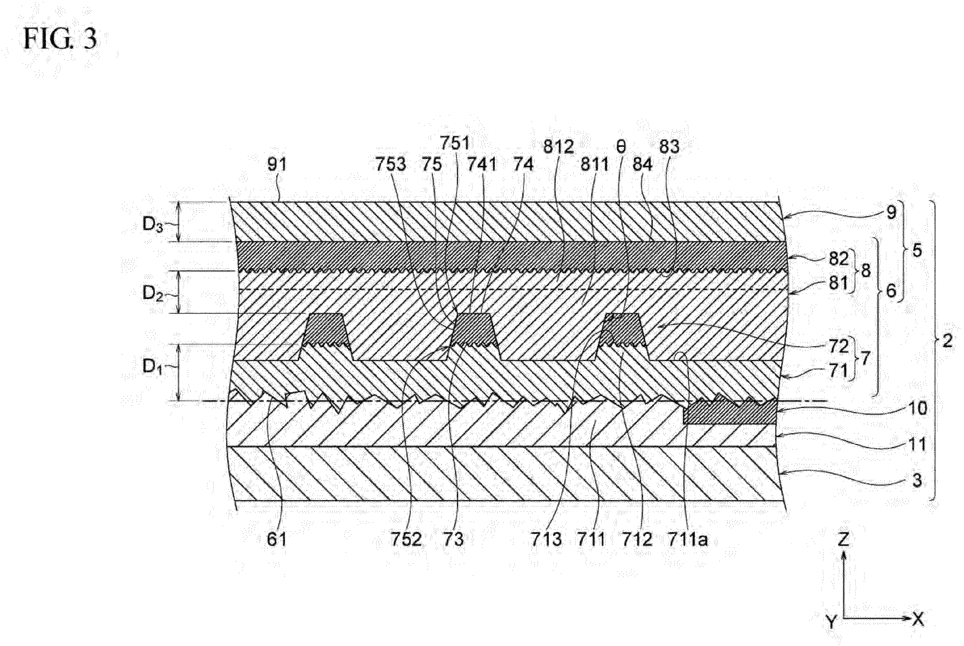

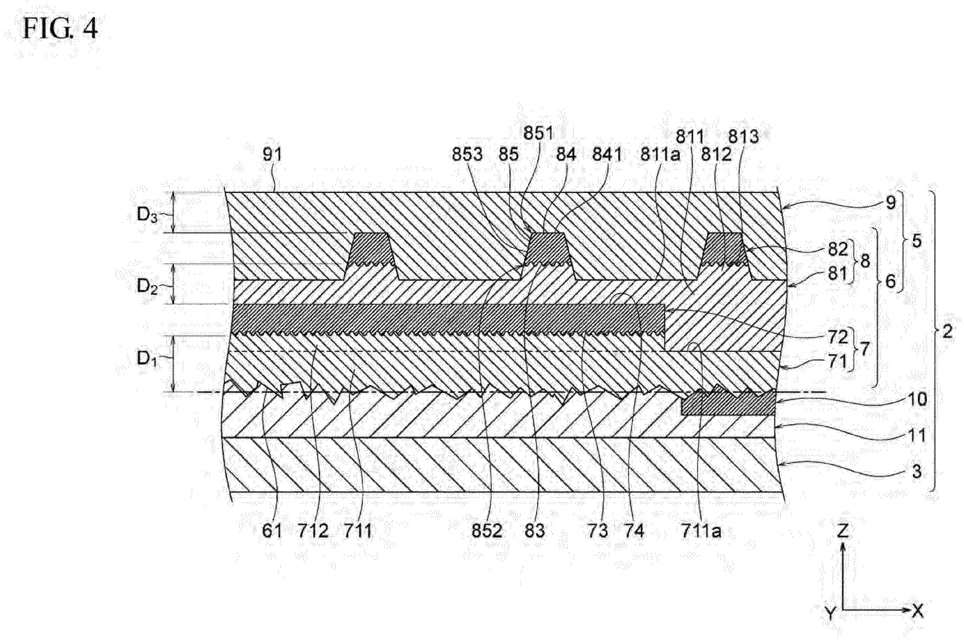

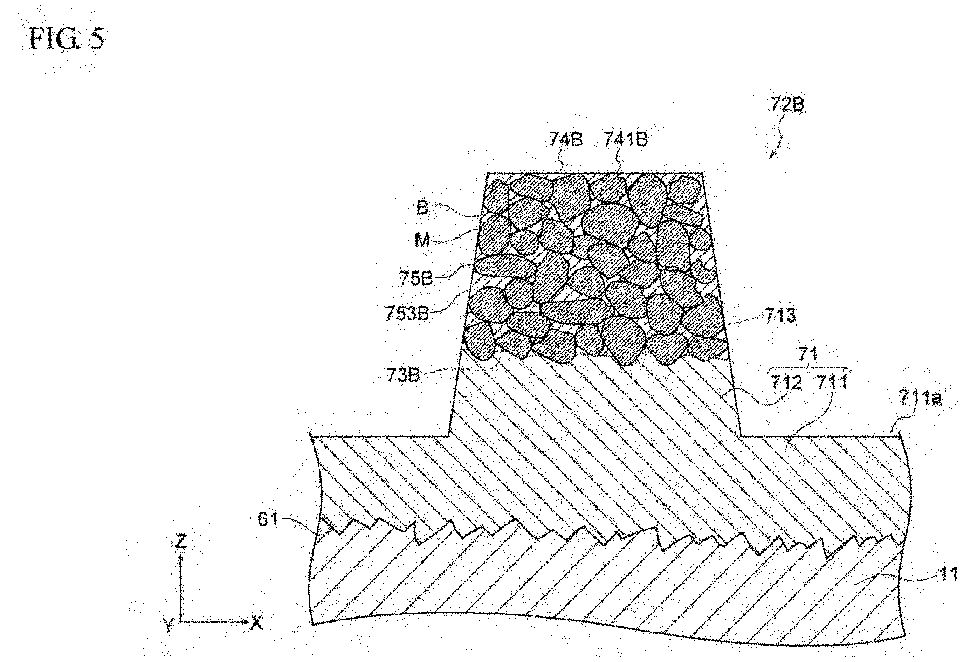

Fig. 1 is a plan view illustrating a touch sensor in one embodiment of the present invention, Fig. 2 is an exploded perspective view illustrating a wiring board in one embodiment of the present invention, Fig. 3 is a cross-sectional view along line III-III of Fig. 1, Fig. 4 is a cross-sectional view along line IV-IV of Fig. 1, and Fig. 5 is a cross-sectional view for illustrating a first conductor portion in one embodiment of the present invention.
As illustrated in Fig. 1, a touch sensor 1 including a wiring board 2 of this embodiment is a projection electrostatic capacitance type touch panel sensor, and for example, is used as an input device having a function of detecting a touch position by being combined with a display device (not illustrated) or the like. The display device is not particularly limited, and a liquid crystal display, an organic EL display, electronic paper, or the like can be used. The touch sensor 1 includes a display region $Z_1$ which is capable of displaying an image to be projected onto the display device (a region inside a dot-and-dash line in Fig. 1), and a non-display region $Z_2$ surrounding the display region $Z_1$ (a region outside the dot-and-dash line in Fig. 1). A detection electrode and a driving electrode (first and second electrodes 77 and 87 described below) are disposed in the display region $Z_1$ to overlap with the image to be projected onto the display device, and a predetermined voltage is periodically applied between two electrodes 77 and 87 from an external circuit (not illustrated). On the other hand, lead-out wiring linked with the electrodes 77 and 87 (first and second lead-out wirings 78 and 88 described below) or a terminal (first and second terminals 79 and 89 described below) is disposed in the non-display region $Z_2$.
In such a touch sensor 1, for example, in a case where a finger of a operator (an external conductor) is close to the touch sensor 1, a capacitor (electrostatic capacitance) is formed between the external conductor and the touch sensor 1, and an electrical state between two electrodes is changed. The touch sensor 1 is capable of detecting an operating position of the operator on the basis of an electrical change between two electrodes. The "touch sensor 1" in this embodiment corresponds to an example of the "touch sensor" in the present invention, and the "wiring board 2" in this embodiment corresponds to an example of the "wiring board" in the present invention.
As illustrated in Fig. 1 and Fig. 2, the wiring board 2 includes a substrate 3, a wiring body 5, a decorative portion 10, and an adhesive portion 11. The wiring board 2 of this embodiment is configured to have transparency (light transmittance) as a whole, in order to ensure visibility of the display device. Furthermore, in Fig. 1, in order to describe the wiring board 2 of this embodiment to be easily understood, a first conductor pattern 76 positioned on a -Z direction side (excluding the first terminal 79) relatively displayed by a broken line, and a second conductor pattern 86 positioned on a +Z direction side is relatively displayed by a solid line. The first and second conductor patterns 76 and 86 will be described below.

The substrate 3 is a transparent plate-like substrate which is capable of transmitting a visible light ray, and supports the wiring body 5. Polyethylene terephthalate (PET), polyethylene naphthalate (PEN), a polyimide resin (PI), a polyether imide resin (PEI), polycarbonate (PC), polyether ether ketone (PEEK), a liquid crystal polymer (LCP), a cycloolefin polymer (COP), a silicone resin (SI), an acrylic resin, a phenolic resin, an epoxy resin, glass, and the like, can be exemplified as a material configuring the substrate 3. An easily adhesive layer or an optical adjusting layer may be formed on the substrate 3. The "substrate 3" in this embodiment corresponds to an example of the "support body" in the present invention.

As illustrated in Fig. 2 to Fig. 4, the wiring body 5 includes a main body portion 6 and an overcoat portion 9. The main body portion 6 includes a first layered portion 7 and a second layered portion 8. In the wiring body 5 of this embodiment, the first layered portion 7, the second layered portion 8, and the overcoat portion 9 are sequentially stacked from a side of the substrate 3. The "wiring body 5" in this embodiment corresponds to an example of the "wiring body" in the present invention, the "main body portion 6" in this embodiment corresponds to an example of the "main body portion" in the present invention, the "first layered portion 7" in this embodiment corresponds to an example of the "layered portion" in the present invention, the "second layered portion 8" in this embodiment corresponds to an example of the "layered portion" in the present invention, and the "overcoat portion 9" in this embodiment corresponds to an example of the "overcoat portion" in the present invention.

As illustrated in Fig. 3 and Fig. 4, the first layered portion 7 includes a first resin portion 71, and a first conductor portion 72 disposed on the first resin portion 71. The "first resin portion 71" in this embodiment corresponds to an example of the "resin portion" in the present invention, and the "first conductor portion 72" in this embodiment corresponds to an example of the "conductor portion" in the present invention.

The first resin portion 71 is disposed to retain the first conductor portion 72, and for example, is made of an insulating material such as a UV curable resin, a thermosetting resin, a thermoplastic resin and the like. For example, an epoxy resin, an acrylic resin, a polyester resin, a urethane resin, a vinyl resin, a silicone resin, a phenolic resin, and a polyimide resin can be exemplified.

The first resin portion 71 includes a first flat portion 711 and a first protruding portion 712. The first flat portion 711 is a portion of the first resin portion 71 which is formed into the shape of a layer. A first upper surface 711a of the first flat portion 711 is approximately an even surface.

The first protruding portion 712 is integrally formed with the first flat portion 711 on the first flat portion 711. The first protruding portion 712 is disposed corresponding to the first conductor portion 72, and supports the first conductor portion 72. The first protruding portion 712 protrudes towards the overcoat portion 9 from the first flat portion 711 in a width direction cross section of the first conductor portion 72.

The first protruding portion 712 includes a first resin portion contact surface 713 in contact with the first conductor portion 72 (specifically, a first conductor portion contact surface 73 (described below)). As illustrated in Fig. 3, the first resin portion contact surface 713 has an unevenness shape which is complementary with respect to an unevenness shape of the first conductor portion contact surface 73. As illustrated in Fig. 4, the first resin portion contact surface 713 and the first conductor portion contact surface 73 are in a complementary unevenness shapes in the extending direction cross section of the first conductor portion 72. In Fig. 3 and Fig. 4, in order to describe the wiring body 5 of this embodiment to be easily understood, the unevenness shapes of the first resin portion contact surface 713 and the first conductor portion contact surface 73 is exaggerated.

In this embodiment, a thickness $D_1$ of the first resin portion 71 is preferably 10 $\mu$m to 200 $\mu$m, is more preferably 30 $\mu$m to 150 $\mu$m, and is even more preferably 50 $\mu$m to 100 $\mu$m. Furthermore, the thickness $D_1$ of the first resin portion 71 indicates a thickness obtaining by summing up the thickness of the first flat portion 711 and the thickness of the first protruding portion 712.

As illustrated in Fig. 1 and Fig. 2, a plurality of first conductor portions 72 are disposed on the first resin portion 71, and the first conductor pattern 76 is configured of the plurality of first conductor portions 72. The first conductor pattern 76 includes a plurality of first electrodes 77, a plurality of first lead-out wirings 78, and a plurality of first terminals 79. The first electrode 77 is in a reticular shape. Each of the first electrodes 77 extends in a Y direction in the drawing, and the plurality of first electrodes 77 is parallel in an X direction in the drawing. Each of the first lead-out wiring 78 is connected to one longitudinal direction end of each of the first electrodes 77. Each of the first lead-out wirings 78 extends from one longitudinal direction end of each of the first electrodes 77 to the vicinity of the outer edge of the wiring body 5. Each of the first terminals 79 is disposed on the other end of each of the first lead-out wirings 78. The first terminal 79 is electrically connected to an external circuit (not illustrated).

The shape of each reticulation configuring a reticular shape of the first electrode 77 is not particularly limited. For example, the shape of the reticulation may be a triangle such as an equilateral triangle, an isosceles triangle, and a rectangular triangle, or may be a quadrangle such as a parallelogram and a trapezoid. Alternatively, the shape of the reticulation may be an n-sided polygon such as a hexagon, an octagon, a dodecagon, and an icosagon, a circle, an ellipse, a star, or the like. Thus, a geometric pattern obtained by repeating various diagram units can be used as the shape of each reticulation of the first electrode 77. The first lead-out wiring 78 and the first terminal 79 may be in a reticular shape, as with the first electrode 77.

Next, the first conductor portion 72 of this embodiment will be described. The first conductor portion 72 linearly extends, and the plurality of first conductor portions 72 intersect with each other, and thus, the reticular shape described above is formed. The first conductor portion 72 may be in a curve shape, a horseshoe shape, a zigzag line shape, or the like. In addition, the width of the first conductor portion 72 may be changed along the extending direction of the first conductor portion 72.

The width of the first conductor portion 72 (the maximum width) is preferably 50 nm to 1000 $\mu$m, is more preferably 500 nm to 150 $\mu$m, is even more preferably 1 $\mu$m to 10 $\mu$m, and still more preferably 1 $\mu$m to 5 $\mu$m. In addition, the height of the first conductor portion 72 is preferably 50 nm to 3000 $\mu$m, is more preferably 500 nm to 450 $\mu$m, and is even more preferably 500 nm to 10 $\mu$m.

The first conductor portion 72 is configured of a binder resin, and conductive particles (a conductive powder) dispersed in the binder resin. A metal material such as silver, copper, nickel, tin, bismuth, zinc, indium, and palladium, and a carbon-based material such as a graphite, carbon black (furnace black, acetylene black, and ketchen black), a carbon nanotube, and a carbon nanofiber, can be exemplified as the conductive particles. A metal salt which is a salt of the metal material described above may be used instead of the conductive particles.

For example, conductive particles having a particle diameter $\phi$ of greater than or equal to 0.5 $\mu$m and less than or equal to 2 $\mu$m (0.5 $\mu$m $\leq \phi \leq$ 2 $\mu$m) can be used as the conductive particles contained in the first conductor portion 72, according to the width of the first conductor portion 72 to be formed. Furthermore, it is preferable to use conductive particles having an average particle diameter $\phi$ of less than or equal to half of the width of the first conductor portion 72 to be formed, from the viewpoint of stabilizing an electrical resistance value of the first conductor portion 72. In addition, it is preferable to use conductive particles having a specific surface area of greater than or equal to 20 $m^2$/g, which is measured by a BET method.

In a case where a comparatively small electrical resistance value which is less than or equal to a certain value, is obtained as the first conductor portion 72, it is preferable that a metal material is used as the conductive particles, and in a case where a comparatively large electrical resistance value which is greater than or equal to a certain value, is allowed as the first conductor portion 72, it is possible to use a carbon-based material as the conductive particles. It is preferable that the carbon-based material is used as the conductive particles from the viewpoint of improving a haze or total light reflectance of a mesh film.

In addition, as with this embodiment, in a case where the first electrode 77 is in a reticular shape, and thus, light transmittance is applied to the first electrode 77, a conductive material which has excellent conductivity but is opaque (an opaque metal material and an opaque carbon-based material), such as a metal material such as silver, copper, and nickel, and the carbon-based material described above, can be used as a conductive material configuring the first conductor portion 72 of the first electrode 77.

An acrylic resin, a polyester resin, an epoxy resin, a vinyl resin, an urethane resin, a phenolic resin, a polyimide resin, a silicone resin, a fluorine resin, and the like, can be exemplified as the binder resin. Furthermore, the binder resin may be omitted from the material configuring the first conductor portion 72.

Such a first conductor portion 72 is formed by being coated with a conductive paste and by curing the conductive paste. A conductive paste which is obtained by mixing conductive particles, a binder resin, water or a solvent, and various additives, can be exemplified as a specific example of the conductive paste. $\alpha$-Terpineol, butyl carbitol acetate, butyl carbitol, 1-decanol, butyl cellosolve, diethylene glycol monoethyl ether acetate, tetradecane, and the like can be exemplified as the solvent contained in the conductive paste.

A cross-sectional shape of the first conductor portion 72 of this embodiment will be described in detail. As illustrated in Fig. 3, the first conductor portion 72 of this embodiment includes the first conductor portion contact surface 73, a first conductor portion top surface 74, and a first conductor portion side surface 75, on the width direction cross section of the first conductor portion 72. The "first conductor portion contact surface 73" in this embodiment corresponds to an example of the "contact surface" in the present invention, and the "first conductor portion top surface 74" in this embodiment corresponds to an example of the "top surface" in the present invention.

The first conductor portion contact surface 73 is a surface in contact with the first resin portion contact surface 713. The first conductor portion contact surface 73 is in an unevenness shape. The unevenness shape is formed on the basis of surface roughness of the first conductor portion contact surface 73. The surface roughness of the first conductor portion contact surface 73 will be described below in detail.

The first conductor portion top surface 74 is a surface on a side opposite to the first conductor portion contact surface 73 in the first conductor portion 72. The first conductor portion top surface 74 in this embodiment includes a linear first top surface flat portion 741. The width of the first top surface flat portion 741 is greater than or equal to half of the width of the first conductor portion top surface 74 in the width direction cross section of the first conductor portion 72. In this embodiment, approximately the entire first conductor portion top surface 74 is the first top surface flat portion 741. A flatness of the first top surface flat portion 741 is less than or equal to 0.5 μm. The flatness can be defined by a JIS method (JIS B0621 (1984)).

The flatness of the first top surface flat portion 741 is obtained by a non-contact type measurement method using laser light. Specifically, a measurement target is irradiated with strip-like laser light, and an image is formed on an imaging device (for example, a two-dimensional CMOS) by reflection light thereof, and thus, the flatness is measured. As a calculation method of the flatness, a method in which a plane passing through three points maximally separated from each other is set in a target surface, and a maximum value of a deviation thereof is calculated as the flatness (a maximum deflection flatness) is used. The measurement method or the calculation method of the flatness is not particularly limited to the above description. For example, the measurement method of the flatness may be a contact type measurement method using a dial gauge or the like. As the calculation method of the flatness, a method in which a value of a gap formed at the time of interposing a target surface between parallel planes is calculated as the flatness (a maximum inclination type flatness) may be used.

The first conductor portion side surface 75 is interposed between the first conductor portion contact surface 73 and the first conductor portion top surface 74. The first conductor portion side surface 75 is connected to the first conductor portion top surface 74 on one end portion 751, and is connected to the first conductor portion contact surface 73 on the other end portion 752. The first conductor portion side surface 75 and a side surface of the first protruding portion 712 are continuously connected to each other. In this embodiment, two first conductor portion side surfaces 75 and 75 in one first conductor portion 72, are inclined to be close to the center of the first conductor portion 72 as being close to the first overcoat portion 9. In this case, the first conductor portion 72 is in a tapered shape in which the first conductor portion 72 is narrowed as being close to the first overcoat portion 9 on the width direction section of the first conductor portion 72.

The first conductor portion side surface 75 includes a first side surface flat portion 753 on the width direction cross section of the first conductor portion 72. The first side surface flat portion 753 is a linear portion existing on the first conductor portion side surface 75 on the width direction cross section of the first conductor portion 72. A flatness of the first side surface flat portion 753 is less than or equal to 0.5 μm. The first conductor portion side surface 75 of this embodiment is a surface extending onto a virtual straight line (not illustrated) passing through both ends 751 and 752, and thus, approximately the entire first conductor portion side surface 75 is the first side surface flat portion 753.

The shape of the first conductor portion side surface 75 is not particularly limited to the above description. For example, the first conductor portion side surface 75 may be in an arc shape in which the first conductor portion side surface 75 protrudes towards the outside in the width direction cross section of the first conductor portion 72. In this case, the first conductor portion side surface 75 exists on the outside from the virtual straight line passing through the both ends 751 and 752 of the first conductor portion side surface 75. Thus, it is preferable that the first conductor portion side surface 75 is in a shape where the first conductor portion side surface 75 does not exist on the inside from the virtual straight line passing through the both ends in the width direction cross of the conductor portion. For example, in a case where the conductor portion is gradationally widened as being separated from the overcoat portion in the width direction cross section of the conductor portion, it is preferable that the shape of the conductor portion side surface is an arc shape in which the conductor portion side surface is concave towards the inside (that is, a shape in which the skirt of the conductor portion is widened).

An angle θ of a corner portion between the first conductor portion side surface 75 and the first conductor portion top surface 74, is preferably 90° to 170° (90° ≤ θ ≤ 170°), and is more preferably 90° to 120° (90° ≤ θ ≤ 120°) from the viewpoint of suppressing scattering of light in the first conductor portion side surface 75. In this embodiment, in one first conductor portion 72, an angle between one first conductor portion side surface 75 and the first conductor portion top surface 74, and an angle between the other first conductor portion side surface 75 and the first conductor portion top surface 74 are substantially the same.

It is preferable that the surface roughness of the first conductor portion contact surface 73 is relatively greater than surface roughness of the first conductor portion top surface 74 from the viewpoint of rigidly fixing first conductor portion 72 to the first resin portion 71. In this embodiment, the first conductor portion top surface 74 includes a first top surface flat portion 741, and thus, a relationship of the surface roughness in the first conductor portion 72 (a relationship in which the surface roughness of the first conductor portion top surface 74 is relatively greater than the surface roughness of the first conductor portion contact surface 73) is established. Specifically, it is preferable that surface roughness Ra of the first conductor portion contact surface 73 is 0.1 μm to 3 μm, whereas surface roughness Ra of the first conductor portion top surface 74 is 0.001 μm to 1.0 μm. It is more preferable that the surface roughness Ra of the first conductor portion contact surface 73 is 0.1 μm to 0.5 μm, and it is more preferable that the surface roughness Ra of the first conductor portion top surface 74 is 0.001 μm to 0.3 μm. In addition, a ratio of the surface roughness of the first conductor portion top surface 74 with respect to the surface roughness of the first conductor portion contact surface 73, is preferably greater than or equal to 0.01 and less than 1, and is more preferably greater than or equal to 0.1 and less than 1. In addition, it is preferable that the surface roughness of the first conductor portion top surface 74 is less than or equal to 1/5 of the width of the first conductor portion 72 (the maximum width). This surface roughness can be measured by a JIS method (JIS B0601 (revised on March 21, 2013)). The surface roughness of the first conductor portion contact surface 73 or the surface roughness of the first conductor portion top surface 74, may be measured along the width direction of the first conductor portion 72, or may be measured along the extending direction of the first conductor portion 72.

Incidentally, as described in the JIS method (JIS B0601 (revised on March 21, 2013)), the "surface roughness Ra" indicates "arithmetic average roughness Ra". The "arithmetic average roughness Ra" indicates a roughness parameter which is obtained by blocking a long wavelength component (a waviness component) from a sectional curve. The waviness component is separated from the sectional curve, on the basis of a measurement condition necessary for obtaining a feature (for example, a dimension or the like of the target).

In this embodiment, the first conductor portion side surface 75 also includes the first side surface flat portion 753. For this reason, as with the first conductor portion top surface 74, the surface roughness of the first conductor portion contact surface 73 is relatively greater than surface roughness of the first conductor portion side surface 75. The surface roughness Ra of the first conductor portion contact surface 73 is 0.1 $\mu$m to 3 $\mu$m, whereas surface roughness Ra of the first conductor portion side surface 75 is preferably 0.001 $\mu$m to 1.0 $\mu$m, and is more preferably 0.001 $\mu$m to 0.3 $\mu$m. The surface roughness of the first conductor portion side surface 75 may be measured along the width direction of the first conductor portion 72, or may be measured along the extending direction of the conductor portion.

In a case where a ratio of the surface roughness between the first conductor portion contact surface 73 and a surface other than the first conductor portion contact surface 73 (the first conductor portion top surface 74 and the first conductor portion side surface 75) satisfies the ratio described above, a diffused reflection rate on the surface side other than the first conductor portion contact surface 73 (a second main surface 91 (described below) side of the overcoat portion 9) is less than a diffused reflection rate on the first conductor portion contact surface 73 side (a first main surface 61 (described below) side of the main body portion 6). In this case, a ratio of the diffused reflection rate on the surface side other than the first conductor portion contact surface 73 to the diffused reflection rate on the first conductor portion contact surface 73 side, is preferably greater than or equal to 0.1 and less than 1, and is more preferably greater than or equal to 0.3 and less than 1.

An example of the shape of the first conductor portion having a relationship in the surface roughness between the first conductor portion contact surface described above and the surface other than the first conductor portion contact surface, will be described with reference to Fig. 5. At a first conductor portion contact surface 73B of a first conductor portion 72B configured of conductive particles M and a binder resin B, a part of the conductive particles M protrudes from the binder resin B in a width direction cross section of the first conductor portion 72B. Accordingly, the first conductor portion contact surface 73B is in an unevenness shape. On the other hand, in a first conductor portion top surface 74B and a first conductor portion side surface 75B of the first conductor portion 72B, the binder resin B enters between the conductive particles M in the width direction cross section surface of the first conductor portion 72B. A slightly exposed portion of the conductive particles M is scattered on the first conductor portion top surface 74B and the first conductor portion side surface 75B, but the binder resin B covers the conductive particles M. Accordingly, the first conductor portion top surface 74B includes a first top surface flat portion 741B, and the first conductor portion side surface 75B includes a first side surface flat portion 753B. In this case, surface roughness of the first conductor portion contact surface 73B is relatively greater than surface roughness of the first conductor portion top surface 74B, and is relatively greater than surface roughness of the first conductor portion side surface 75B. The binder resin B covers the conductive particles M at the first conductor portion side surface 75B, and thus, electrical insulating properties between the adjacent first conductor portions 72B are improved, and the occurrence of migration is suppressed.

The shape of the conductor portion (the shape of the conductor portion contact surface, the conductor portion top surface, and the conductor portion side surface) is not particularly limited to the above description. In the first conductor pattern 76, the first conductor portion 72 configuring the first electrode 77, the first conductor portion 72 configuring the first lead-out wiring 78, and the first conductor portion 72 configuring the first terminal 79 may be in the same shape, or may be in different shapes. For example, the width of the first conductor portion 72 configuring the first electrode 77, the width of the first conductor portion 72 configuring the first lead-out wiring 78, and the width of the first conductor portion 72 configuring the first terminal 79 may be equal to each other, or may be different from each other. The height of the first conductor portion 72 configuring the first electrode 77, the height of the first conductor portion 72 configuring the first lead-out wiring 78, and the height of the first conductor portion 72 configuring the first terminal 79 may be equal to each other, or may be different from each other.

As illustrated in Fig. 3 and Fig. 4, the second layered portion 8 is disposed on the first layered portion 7. The second layered portion 8 includes a second resin portion 81, and a second conductor portion 82 disposed on the second resin portion 81. The "second resin portion 81" in this embodiment corresponds to an example of the "resin portion" in the present invention, and the "second conductor portion 82" in this embodiment corresponds to an example of the "conductor portion" in the present invention.

The second resin portion 81 is disposed to cover the first conductor portion 72, and is interposed between the first and second conductor portions 72 and 82. In this embodiment, the second resin portion 81 functions as a dielectric body which exists between two electrodes 77 and 87 of the touch sensor 1. The thickness of the second resin portion 81 is adjusted. A detection sensitivity of the touch sensor 1 is adjusted.

The second resin portion 81 includes a second flat portion 811 and a second protruding portion 812, which are formed into the shape of a layer. The second flat portion 811 is directly formed on the first layered portion 7, covers the first conductor portion 72, and covers a first upper surface 711a of the first resin portion 71 in a portion where the first conductor portion 72 does not exist on the first layered portion 7. The first terminal 79 is exposed from a cutout formed on one side of the second flat portion 811. A second upper surface 811a of the second flat portion 811 is approximately an even surface.

The second protruding portion 812 is integrally formed with the second flat portion 811 on the second flat portion 811. The second protruding portion 812 is disposed corresponding to the second conductor portion 82, and supports the second conductor portion 82. The second protruding portion 812 protrudes towards the overcoat portion 9 side from the second flat portion 811, on a width direction cross section surface of the second conductor portion 82.

The second protruding portion 812 includes a second resin portion contact surface 813 in contact with the second conductor portion 82 (specifically, a second conductor portion contact surface 83). As illustrated in Fig. 4, the second resin portion contact surface 813 is in an unevenness shape which is complementary with respect to the unevenness shape of the second conductor portion contact surface 83. As illustrated in Fig. 3, the second resin portion contact surface 813 and the second conductor portion contact surface 83 are in a complementary unevenness shape, on the extending direction cross sectional of the second conductor portion 82. In Fig. 3 and Fig. 4, in order to describe the wiring body 5 of this embodiment to be easily understood, the unevenness shape of the second resin portion contact surface 813 and the second conductor portion contact surface 83 is exaggeratingly illustrated.

In this embodiment, it is preferable that a thickness $D_2$ of the second resin portion 81 is 20 $\mu$m to 200 $\mu$m. Furthermore, the thickness $D_2$ of the second resin portion 81 indicates a thickness obtaining by summing up the thickness of the second flat portion 811 and the thickness of the second protruding portion 812.

As illustrated in Fig. 1 and Fig. 2, a plurality of second conductor portions 82 are disposed on the second resin portion 81, and the second conductor pattern 86 is configured of the plurality of second conductor portions 82. The second conductor pattern 86 includes the second electrode 87, the second lead-out wiring 88, and the second terminal 89. The second electrode 87 is in a reticular shape. Each of the second electrodes 87 extends in the X direction in the drawing, and a plurality of second electrodes 87 is parallel in the Y direction in the drawing. Each of the second lead-out wirings 88 is connected to one longitudinal direction end of each of the second electrode 87. Each of the second lead-out wirings 88 extends from one longitudinal direction end of each of the second electrodes 87 to the vicinity of the outer edge of the wiring body 5. The second terminal 89 is disposed on the other end of each of the second lead-out wirings 88. The second terminal 89 is electrically connected to an external circuit (not illustrated).

The same shape as the shape of each reticulation configuring the reticular shape of the first electrode 77 can be adopted as the shape of each reticulation configuring the reticular shape of the second electrode 87. As with the second electrode 87, the second lead-out wiring 88 or the second terminal 89 may be in a reticular shape.

The second conductor portion 82 of this embodiment basically has the same configuration as that of the first conductor portion 72 described above. Therefore, the first conductor portion contact surface 73 will be replaced with the second conductor portion contact surface 83, the first conductor portion top surface 74 will be replaced with the second conductor portion top surface 84, and the first conductor portion side surface 75 will be replaced with the second conductor portion side surface 85, and the repeated description will be omitted, and the description of the first conductor portion 72 will be referred. In addition, the first top surface flat portion 741 will be replaced with the second top surface flat portion 841, the end portions 751 and 752 will be replaced with the end portions 851 and 852, and the first side surface flat portion 753 will be replaced with the second side surface flat portion 853, the repeated description will be omitted, and the description of the first conductor portion 72 will be referred.

As illustrated in Fig. 3 and Fig. 4, the overcoat portion 9 is disposed on the main body portion 6 to cover the second conductor portion 82 of the second layered portion 8. The overcoat portion 9 has a function of protecting the main body portion 6 from the outside. In addition, the overcoat portion 9 covers the second conductor portion 82, and thus, scattering of light or the like is suppressed on a surface of the second conductor portion 82, and visibility of the wiring body 5 is improved.

The overcoat portion 9 of this embodiment is directly formed on the second layered portion 8, covers the second conductor portion 82, and covers the second upper surface 811a of the second resin portion 81 in a portion where the second conductor portion 82 does not exist on the second layered portion 8. The first terminal 79 is exposed from a cutout formed on one side of the overcoat portion 9. In addition, the second terminal 89 is exposed from the cutout formed on one side of the overcoat portion 9.

A resin material such as an UV curable resin, a thermosetting resin, a thermoplastic resin, and the like can be used as a material configuring the overcoat portion 9. An epoxy resin, an acrylic resin, a polyester resin, a urethane resin, a vinyl resin, a silicone resin, a phenolic resin, a polyimide resin, and the like can be exemplified as the UV curable resin, the thermosetting resin, and the thermoplastic resin.

It is preferable that the thickness of the overcoat portion 9 satisfies Expression (1) and Expression (2) described below.

$$D_3 < D_2 \dots (1)$$

$$D_3 < D_1 \dots (2)$$

Here, in Expressions (1) and (2) described above, $D_1$ is the thickness of the first resin portion 71, $D_2$ is the thickness of the second resin portion 81, and $D_3$ is the thickness of the overcoat portion 9. The thickness $D_3$ of the overcoat portion 9 is a distance from the second conductor portion top surface 84 of the second conductor portion 82 covered with the overcoat portion 9 to the second main surface 91 (described below).

By satisfying Expression (1) described above, it is possible to ensure rigidity of the second resin portion 81 supporting the second conductor portion 82, and to reduce the thickness of the entire wiring body 5. In addition, by satisfying Expression (2) described above, it is possible to ensure rigidity of the first resin portion 71 supporting the first conductor portion 72, and to reduce the thickness of the entire wiring body 5. In this embodiment, the thickness $D_3$ of the overcoat portion 9 is preferably 5 $\mu$m to 100 $\mu$m, is more preferably 10 $\mu$m to 70 $\mu$m, and is even more preferably 20 $\mu$m to 50 $\mu$m.

A reference numeral of 61 illustrated in Fig. 3 and Fig. 4, is a main surface (hereinafter, also referred to as the "first main surface 61") on a side opposite to the overcoat portion 9 side in the main surface of the main body portion 6. A reference numeral of 91 illustrated in Fig. 3 and Fig. 4 is a main surface (hereinafter, also referred to as the "second main surface 91") on a side opposite to the main body portion 6 side in the main surface of the overcoat portion 9. Furthermore, herein, the "main surface" indicates a surface extending in an X-Y plane surface which is orthogonal to the Z direction (a stacking direction of the resin portion and the conductor portion in the layered portion).

In this embodiment, the first main surface 61 configures one main surface of the wiring body 5. On the other hand, the second main surface 91 configures the other main surface of the wiring body 5. In a state where the decorative portion 10 or the adhesive portion 11 is not disposed on the wiring body 5, the first and second main surfaces 61 and 91 are exposed to the outside of the wiring body 5. In the wiring board 2 of this embodiment, the first main surface 61 is disposed on a side close to the substrate 3 with respect to the second main surface 91. On the other hand, the second main surface 91 is disposed on a side separated from the substrate 3 with respect to the first main surface 61.

In this embodiment, surface roughness of the first main surface 61 is relatively greater than surface roughness of the second main surface 91. It is preferable that surface roughness Ra of the first main surface 61 is 10 nm to 1000 nm, whereas the surface roughness Ra of the second main surface 91 is less than or equal to 5 nm, as a relationship in the surface roughness of the first and second main surfaces 61 and 91. It is more preferable that the surface roughness Ra of the first main surface 61 is 10 nm to 100 nm. In this embodiment, approximately the entire first main surface 61 has uniform surface roughness. In addition, approximately the entire second main surface 91 has uniform surface roughness.

In a case where the first and second main surfaces 61 and 91 are positioned in the wiring body 5 as described above, the first conductor portion contact surface 73 of the first conductor portion 72 is positioned on the same side as the first main surface 61 in the first and second main surfaces 61 and 91, with respect to the first conductor portion top surface 74. In addition, the first conductor portion top surface 74 of the first conductor portion 72 is positioned on the same side as the second main surface 91 in the first and second main surfaces 61 and 91, with respect to the first conductor portion contact surface 73.

In this case, it is preferable that the surface roughness of the first conductor portion contact surface 73 is relatively greater than the surface roughness of the first main surface 61, and the surface roughness of the first conductor portion top surface 74 is relatively greater than the surface roughness of the second main surface 91. Accordingly, it is possible to prevent degradation in the visibility of the wiring body 5, while suppressing peeling between the first resin portion 71 and the first conductor portion 72, and peeling between the first conductor portion 72 and the second resin portion 81.

The decorative portion 10 is disposed in order to improve appearance design of the touch sensor 1, and to hide a component which is not necessary to be visible. It is necessary to use a material which is not capable of transmitting light (a visible light ray), or is capable of attenuating light (a visible light ray), as a material configuring the decorative portion 10, and for example, a black photosensitive resin composition including a light shielding material such as carbon black, titanium oxynitride, and titanium black.

The decorative portion 10 is formed into the shape of a frame, along the outer edge of the wiring body 5, and includes a rectangular opening approximately in the central of the decorative portion 10. The decorative portion 10 of this embodiment is directly disposed on the first main surface 61 of the main body portion 6. In this case, the surface roughness of the first main surface 61 is relatively large, and thus, an adhering force between the wiring body 5 and the decorative portion 10 is improved.

In the plan view, a portion overlapping with the decorative portion 10 is not visible from the outside. A range overlapping with the decorative portion 10 includes the non-display region $Z_2$ of the touch sensor 1. On the other hand, in the plan view, the portion overlapping with the opening approximately in the central of the decorative portion 10 transmits a visible light ray. A range overlapping with the opening approximately in the central of the decorative portion 10 includes the display region $Z_1$ of the touch sensor 1.

The adhesive portion 11 is used in order to stick the wiring body 5 to the substrate 3. A known optical clear adhesive (OCA) such as an acrylic resin-based adhesive agent, a urethane resin-based adhesive agent, and a polyester resin-based adhesive agent, can be used as the adhesive portion 11. The adhesive portion 11 of this embodiment is disposed on the first main surface 61 of the main body portion 6 to be interposed between the substrate 3 and the wiring body 5. At this time, the adhesive portion 11 also covers the decorative portion 10 on the first main surface 61 of the main body portion 6.

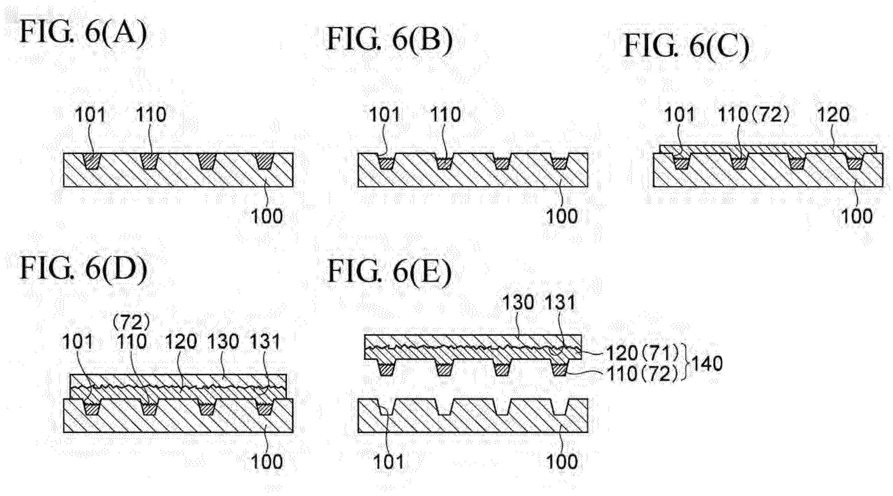

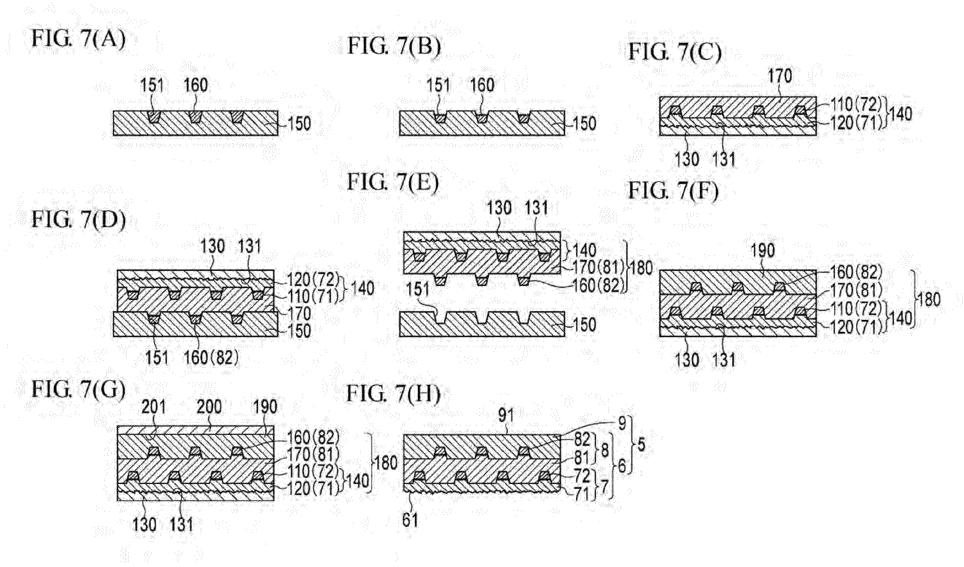

Next, a manufacturing method of the wiring body 5 of this embodiment will be described. Fig. 6(A) to Fig. 6(E), and Fig. 7(A) to Fig. 7(H) are cross-sectional views for illustrating a manufacturing method of a wiring body in one embodiment of the present invention.

First, as illustrated in Fig. 6(A), a first intaglio 100 on which a first concave portion 101 having a shape corresponding to the shape of the first conductor portion 72 is formed is filled with a first conductive material 110. The conductive paste described above is used as the first conductive material 110 filling the first concave portion 101 of the first intaglio 100. Silicon, nickel, and glass such as silicon dioxide, ceramics, organic silicas, glassy carbon, a thermoplastic resin, a photocurable resin, and the like can be exemplified as a material configuring the first intaglio 100. It is preferable that a release layer made of a black lead-based material, a silicone-based material, a fluorine-based material, a ceramic-based material, an aluminum-based material or the like is formed on a surface of the concave portion 101 in order to improve releasability.

For example, a dispense method, an ink jet method, or a screen printing method can be exemplified as a method of filling the first concave portion 101 of the first intaglio 100 with the first conductive material 110. Alternatively, a method of wiping, scraping, sucking, sticking, rinsing, or blowing the first conductive material 110 which is applied to a portion other than the first concave portion 101 after performing coating by a slit coating method, a bar coating method, a blade coating method, a dip coating method, a spray coating method, or a spin coating method, can be exemplified. The filling method can be suitably used according to the the composition of the conductive material 110, the shape of the first intaglio 100 or the like.

Next, as illustrated in Fig. 6(B), the first conductive material 110 filling the first concave portion 101 is heated and cured (a first step). A heating condition of the first conductive material 110 can be suitably set according to the composition of the first conductive material 110 or the like.

Here, the volume of the first conductive material 110 shrinks with a heating treatment. At this time, a shape of an inner wall surface of the first concave portion 101 is transferred to a portion of the first conductive material 110 which is in contact with the inner wall surface of the concave portion 101, and thus, the portion is in a flat shape. On the other hand, a portion of the first conductive material 110 which is not in contact with the inner wall surface of the first concave portion 101 is not affected by the shape of the inner wall surface of the first concave portion 101. For this reason, a fine unevenness shape is formed in the portion of the first conductive material which is not in contact with the inner wall surface of the first concave portion 101. Accordingly, the first conductor portion 72 is formed.

A treatment method of the first conductive material 110 is not particularly limited to heating. The first conductive material 110 may be irradiated with an energy ray such as an infrared ray, an ultraviolet ray, or laser light or the first conductive material 110 may only be dried. Two or more types of treatment methods may be combined.

Next, as illustrated in Fig. 6(C), a first resin material 120 for forming the first resin portion 71 is applied onto the first intaglio 100. The resin material described above configuring the first resin portion 71 is used as the first resin material 120. A screen printing method, a spray coating method, a bar coating method, a dipping method, and an ink jet method can be exemplified as a method of applying the first resin material 120 on the first intaglio 100. According to such coating, the first resin material 120 enters the first concave portion 101 having a gap which is generated by the volume contraction of the first conductive material 110 described above.

Next, as illustrated in Fig. 6(D), a first substrate 130 is disposed on the first intaglio 100, and the first substrate 130 is pressed against the first intaglio in a state where the first resin material 120 is interposed between the first substrate 130 and the first intaglio 100 (a second step). Then, the first resin material 120 is cured (a third step). Irradiation of an energy ray such as an ultraviolet ray, an infrared ray, laser light, heating, heating and cooling, drying and the like can be exemplified as a method of curing the first resin material 120. Accordingly, the first resin portion 71 is formed.

Here, for example, a stainless steel plate such as bright annealing-finished SUS304 stainless steel or SUS430 stainless steel is used as the first substrate 130. Surface roughness Ra of a main surface (hereinafter, referred to as a "third main surface 131") on a side facing the first resin material 120 out of main surfaces of the first substrate 130 is preferably 10 nm to 1000 nm, and is more preferably 10 nm to 100 nm.

Furthermore, a formation method of the first resin portion 71 is not particularly to the above description. For example, the first resin material 120 may be formed by preparing the substrate 3 on which the first resin material 120 is approximately uniformly applied on the first substrate 130, pressing the first substrate 130 against the first intaglio 100 so that the first resin material 120 enters the first concave portion 101 of the first intaglio 100, and curing the first resin material 120 while maintaining such a state.

Next, as illustrated in Fig. 6(E), a first intermediate 140 including the first conductor portion 72 (the first conductive material 110) and the first resin portion 71 (the first resin material 120), and the first substrate 130 adhering to the first intermediate 140 are integrally released from the first intaglio 100 (a fourth step).

Next, as illustrated in Fig. 7(A), a second intaglio 150 on which a second concave portion 151 corresponding to the shape of the second conductor portion 82 is formed is prepared. The same material as the material of which the first intaglio 100 is made is used as a material of which the second intaglio 150 is made. As with the first intaglio 100, a release layer (not illustrated) may be formed on the surface of the second intaglio 150 in advance.

Next, as illustrated in Fig. 7(B), the second concave portion 151 of the second intaglio 150 is filled with a second conductive material 160 for forming the second conductor portion 82, and the second conductive material 160 is cured. The conductive paste described above is used as the second conductive material 160. The same method as the method of filling the first concave portion 101 with the first conductive material is used as a method of filling the second concave portion 151 with the second conductive material 160. The same method as the method of curing the first conductive material 110 is used as a method of curing the second conductive material 160.

Next, as illustrated in Fig. 7(C), a second resin material 170 for forming the second resin portion 81 is applied on the first intermediate 140 so as to cover the first conductor portion 72. The material of which the second resin portion 81 is made is used as the second resin material 170. It is preferable that a viscosity of the second resin material 170 is 1 mPa·s to 10,000 mPa·s in terms of ensuring sufficient fluidity at the time of coating. In addition, it is preferable that a storage elastic modulus of the resin after being cured, is greater than or equal to $10^6$ Pa and less than or equal to $10^9$ Pa in terms of durability of the first conductor portion 72 or the second conductor portion 82. The same method as the method of applying the first resin material is used as a method of applying the second resin material 170.

Next, as illustrated in Fig. 7(D), the first intermediate 140 is disposed on the second intaglio 150, and the first intermediate 140 is pressed against the second intaglio 150 so that the second resin material 170 enters the second concave portion 151 of the second intaglio 150 (specifically, an air gap which is generated by the volume contraction of the second conductive material 160), and the second concave portion 151 is cured. A pressure force at the time of pressing the first intermediate 140 against the second intaglio 150 is preferably 0.001 MPa to 100 MPa, and is more preferably 0.01 MPa to 10 MPa. The pressure can be performed by using a pressure roller or the like. The same method as the method of curing the first resin material 120 is used as a method of curing the second resin material 170. Accordingly, the second resin portion 81 is formed, and the first intermediate 140 and the second conductor portion 82 are adhesively fixed to each other through the second resin portion 81.

Next, as illustrated in Fig. 7(E), a second intermediate 180 including the first intermediate 140, the second resin portion 81 (the second resin material 170), and the second conductor portion 82 (the second conductive material 160), and the first substrate 130 adhering to the second intermediate 180 are integrally released from the second intaglio 150.

Next, as illustrated in Fig. 7(F), in order to form the overcoat portion 9, a third resin material 190 is applied on the second intermediate 180 to cover the second conductor portion 82. The material of which the overcoat portion 9 described above is made is used as a material of which the third resin material 190 is made. A screen printing method or a die coating method is used as a method of applying the third resin material 190.

Next, as illustrated in Fig. 7(G), a second substrate 200 is pressed against the second intermediate 180 from a side opposite to the first substrate 130 side, through the third resin material 190 (a fifth step). Then, the third resin material 190 is cured in a state where the second substrate 200 is pressed against the second intermediate 180 through the third resin material 190 (a sixth step). The same method as the method of curing the first resin material 120 described above is used as a method of curing the third resin material 190. Accordingly, the overcoat portion 9 is formed.

Here, a glass substrate of which a release layer is formed on a surface manufactured by a float method or the like (EAGLE XG; manufactured by Corning Incorporated) is used as the second substrate 200. A fluorine-based resin such as polytetrafluoroethylene (PTFE), a silane-based material such as perfluoroalkyl group-containing silane (FAS) and the like are used as the release layer. It is preferable that surface roughness Ra of a main surface (hereinafter, also referred to as a "fourth main surface 201") on a side facing the third resin material 190 out of main surfaces of the second substrate 200 is less than or equal to 5 nm.

In the second intermediate 180, a surface shape of the third main surface 131 is transferred to a portion adhering to the third main surface 131 of the first substrate 130. On the other hand, in the overcoat portion 9, a surface shape of the fourth main surface 201 is transferred to a portion adhering to the fourth main surface 201 of the second substrate 200. Here, in this embodiment, surface roughness of the third main surface 131 of the first substrate 130 is relatively greater than surface roughness of the fourth main surface 201 of the second substrate 200. Accordingly, the first main surface 61 having relatively large surface roughness, which depends on the surface roughness of the third main surface 131, is formed in the portion adhering to the third main surface 131 in the second intermediate 180. The second main surface 91 having relatively small surface roughness, which depends on the surface roughness of the fourth main surface 201, is formed in the portion adhering to the fourth main surface 201 in the overcoat portion 9.

Next, as illustrated in Fig. 7(H), the first substrate 130 is released from the second intermediate 180, and the second substrate 200 is released from the second intermediate 180 (a seventh step). Accordingly, it is possible to obtain the wiring body 5. The sequence of the releasing of the first substrate 130 from the second intermediate 180 and the releasing of the second substrate 200 from the second intermediate 180 is not particularly limited.

Furthermore, the decorative portion 10 is formed on the first main surface 61 by a screen printing method after the wiring body 5 is obtained. Then, the substrate 3 is pressed against the wiring body 5 from the first main surface 61 side through a transparent adhesive agent for forming the adhesive portion 11, and the transparent adhesive agent is cured, and thus, it is possible to obtain the wiring board 2.

The wiring body 5, the wiring board 2, and the touch sensor 1 of this embodiment have the following effects.

In general, scattering of light or the like is suppressed by smoothing the surface of the wiring body (in particular, the front and rear main surfaces), and thus, visibility is improved. Therefore, it is desirable that the surface of the wiring body is a smooth surface having small surface roughness in terms of improving the visibility. However, in a case where the wiring body is mounted on the target, the adhering force between the wiring body and the target decreases at the time of performing smoothing up to the surface of the wiring body on a side facing the target, and there is a concern that the wiring body after being mounted is unintentionally peeled off from the target.

In contrast, in this embodiment, the surface roughness of the first main surface 61 of the main body portion 6 is relatively greater than the surface roughness of the second main surface 91 of the overcoat portion 9. In this case, the wiring body 5 is mounted on the substrate 3 in a state where the first main surface 61 faces the substrate 3 (the target), and thus, it is possible to improve the adhering force between the wiring body 5 and the substrate 3. On the other hand, scattering of light or the like is suppressed on the second main surface 91, and thus, it is possible to improve the visibility of the wiring body 5. In particular, the surface roughness Ra of the first main surface 61 is 10 nm to 100 nm, whereas the surface roughness Ra of the second main surface 91 is less than or equal to 5 nm, and thus, the effect described above becomes more remarkable. Specifically, the surface roughness Ra of the first main surface 61 is greater than or equal to 10 nm, and thus, it is possible to sufficiently ensure the adhering force between the wiring body 5 and the substrate 3, and the surface roughness Ra of the first main surface 61 is less than or equal to 100 nm, and thus, it is possible to suppress scattering of light or the like on the first main surface 61, and to improve the visibility of the wiring body 5. In addition, the surface roughness Ra of the second main surface 91 is less than or equal to 5 nm, and thus, even in a state where the wiring body 5 is not bonded to the adhesive portion 11, it is possible to suppress scattering of light or the like on the second main surface 91, and to improve the visibility of the wiring body 5.

Further, in the wiring board 2 of this embodiment, the first main surface 61 is disposed on a side close to the substrate 3 with respect to the second main surface 91, and the adhesive portion 11 is disposed on the first main surface 61 to be interposed between the substrate 3 and the wiring body 5. In this case, the adhesive portion 11 enters the concavities and convexities of the first main surface 61, and thus, scattering of light or the like is suppressed on the first main surface 61. As a result thereof, it is possible to realize a high transmittance in the wiring board 2, and to improve the visibility of the wiring board 2.

In addition, in this embodiment, the first conductor portion 72 is in a tapered shape in which the first conductor portion 72 is narrowed as being close to the overcoat portion 9. For this reason, in the first conductor portion 72, the angle of the corner portion between the first conductor portion top surface 74 and the first conductor portion side surface 75 increases, and scattering of light or the like in the corner portion is suppressed. Accordingly, the visibility of the wiring body 5 is further improved. In addition, the first conductor portion 72 easily enters the second resin portion 81 covering the first conductor portion, and thus, it is possible to prevent the first conductor portion 72 (the first layered portion 7) and the second resin portion 81 (the second layered portion 8) from being peeled off. In addition, in the second layered portion 8, the second conductor portion 82 is in a tapered shape in which the second conductor portion 82 is narrowed as being close to the overcoat portion 9, and thus, it is possible to further improve the visibility of the wiring body 5, and to prevent the second conductor portion 82 (the second layered portion 8) and the overcoat portion 9 from being peeled off.

In addition, in this embodiment, the first conductor portion contact surface 73 of the first conductor portion 72 is positioned on the same side as the first main surface 61 out of the first and second main surfaces 61 and 91 with respect to the first conductor portion top surface 74 of the first conductor portion 72. In addition, the first conductor portion top surface 74 is positioned on the same side as the second main surface 91 in the first and second main surfaces 61 and 91 with respect to the first conductor portion contact surface 73. In this case, a surface having relatively small surface roughness in the first conductor portion contact surface 73 and the first conductor portion top surface 74 (that is, the first conductor portion top surface 74) and a surface having relatively small surface roughness in the first and second main surfaces 61 and 91 (that is, the second main surface 91) are positioned on the same side in the wiring body 5. For this reason, it is possible to further suppress scattering of light or the like on one side of the wiring body 5, and to further improve the visibility of the wiring body 5. The second conductor portion 82 has the same configuration as that of the first conductor portion 72, and thus, it is possible to obtain the same function effect as described above, in the wiring body 5 including the second conductor portion 82.

Further, as with this embodiment, the first conductor portion top surface 74 having relatively small surface roughness out of the first conductor portion contact surface 73 and the first conductor portion top surface 74, and the second main surface 91 having relatively small surface roughness in the first and second main surfaces 61 and 91, are positioned on the same side, and thus, it is possible to improve a test accuracy of the wiring body 5. That is, high visibility is required for a touch position detection mechanism such as the wiring body 5 of this embodiment, in order to be built in a touch sensor, and in a case where air bubbles are mixed into the wiring body, or dirt is attached to the wiring body, a haze is deteriorated, and the entire wiring body is clouded. For this reason, the visibility of the wiring body notably decreases.

A test of the presence or absence of the air bubbles and the dirt in the wiring body, for example, is performed by a non-contact type test method using an LED or the like. In this case, when the surface of the wiring body on a side on which LED light is rough, the LED light is scattered in the concavities and convexities of the surface, and becomes a noise, and thus, it is not possible to accurately evaluate the air bubbles or the dirt. The same applies to a case where a portion including a rough surface exists in the wiring body, within a range where the LED light is irradiated.

In contrast, in this embodiment, the first conductor portion top surface 74 having relatively small surface roughness and the second main surface 91 having relatively small surface roughness are positioned on the same side in the wiring body 5. In this case, the first conductor portion top surface 74 and the second main surface 91 are irradiated with laser light from a side facing the first conductor portion top surface 74 and the second main surface 91, and thus, scattering of the laser light or the like hardly occurs, and it is possible to more accurately detect the air bubbles or the dirt in the wiring body 5. Accordingly, it is possible to improve the test accuracy of the wiring body 5.

In addition, in this embodiment, the decorative portion 10 is directly disposed on the first main surface 61. It is necessary that the above-mentioned material of which the decorative portion 10 is made is the material which is not capable of transmitting light or is capable of attenuating light. There are few choices in the material of which the decorative portion 10 is made. In a case where according to compatibility between the material configuring the decorative portion and a material configuring a portion in which the decorative portion is disposed, it is not easy to change the material configuring the decorative portion even in a case where it is not possible to sufficiently ensure an adhering force therebetween. For this reason, it is not possible to suppress peeling between the wiring body and the decorative portion.

In contrast, in this embodiment, the surface roughness Ra of the first main surface 61 on which the decorative portion 10 is disposed increases. Accordingly, it is possible to allow the wiring body 5 (specifically, the first resin portion 71) to rigidly adhere to the decorative portion 10 by an anchor effect, and thus, it is possible to suppress peeling between the wiring body 5 and the decorative portion 10.

Furthermore, as with this embodiment, the decorative portion 10 is directly disposed on the wiring body 5, and thus, it is possible to improve a positioning accuracy of the first and second electrodes 77 and 87 of the wiring body 5, and the decorative portion 10.

In addition, in this embodiment, the surface roughness of the first conductor portion contact surface 73 is relatively greater than the surface roughness of the first main surface 61 on the first conductor portion contact surface 73 and the first main surface 61 which are positioned on the same side in the wiring body 5. Thus, the surface roughness of the first conductor portion contact surface 73 of the linear first conductor portion 72 having a small contact area is set to be relatively large, and thus, it is possible to improve the adhering force between the first resin portion 71 and the first conductor portion 72, and to suppress peeling therebetween. On the other hand, the surface roughness of the first main surface 61, which easily affects the visibility of the wiring body 5, is set to be relatively small, and thus, it is possible to suppress scattering of light or the like on the first main surface 61, and to improve the visibility of the wiring body 5.

In addition, the surface roughness of the first conductor portion top surface 74 is relatively greater than the surface roughness of the second main surface 91, on the first conductor portion top surface 74 and the second main surface 91 which are positioned on the same side in the wiring body 5. Thus, the surface roughness of the first conductor portion top surface 74 of the linear first conductor portion 72 having a small contact area, is set to be relatively large, and thus, it is possible to improve the adhering force between the first conductor portion 72 and the second resin portion 81, and to suppress peeling therebetween. On the other hand, the surface roughness of the second main surface 91, which easily affects the visibility of the wiring body 5, is set to be relatively small, and thus, it is possible to suppress scattering of light or the like on the second main surface 91, and to improve the visibility of the wiring body 5. Furthermore, in this embodiment, the second conductor portion 82 has the same configuration as that of the first conductor portion 72. For this reason, it is possible to obtain the function effect described above in the wiring body 5.

Embodiments heretofore explained are described to facilitate understanding of the present invention and are not described to limit the present invention. It is therefore intended that the elements disclosed in the above embodiments include all design changes and equivalents to fall within the technical scope of the present invention.

For example, in this embodiment, the first conductor portion contact surface 73 is positioned on the same side as the first main surface 61 in the first and second main surfaces 61 and 9, with respect to the first conductor portion top surface 74, and the first conductor portion top surface 74 is positioned on the same side as the second main surface 91 in the first and second main surfaces 61 and 91, with respect to the first conductor portion contact surface 73, but the position is not particularly limited thereto. For example, the first conductor portion contact surface may be positioned on the same side as the second main surface in the first and second main surfaces, with respect to the first conductor portion top surface, and the first conductor portion top surface may be positioned on the same side as the first main surface in the first and second main surfaces, with respect to the first conductor portion contact surface. In the manufacturing method described above, the wiring body of this example can be manufactured by using smooth glass such as alkali-free glass, on which the release layer is not formed, as the first substrate, and by using a stainless steel plate having surface roughness Ra of 10 nm to 100 nm, on which the release layer is formed, as the second substrate.

The touch sensor of this embodiment is the projection electrostatic capacitance type touch sensor formed of the wiring body including two layered portions, but is not particularly limited thereto, and the present invention can also be applied to a surface (capacitive coupling) electrostatic capacitance type touch sensor formed of one layered portion.

For example, in this embodiment, the metal material or the carbon-based material is used as the conductive material (the conductive particles) configuring the first and second conductor portions 72 and 82, but the conductive material is not particularly limited thereto, and the metal material and the carbon-based material may be used by being mixed. In this case, for example, in a case of describing the first conductor portion 72 as an example, the carbon-based material may be provided on the first conductor portion top surface 74 side of the first conductor portion 72, and the metal material may be provided on the first conductor portion contact surface 73 side. In addition, on the contrary, the metal material may be provided on the first conductor portion top surface 74 side of the first conductor portion 72, and the carbon-based material may be provided on the first conductor portion contact surface 73 side.

In this embodiment, the decorative portion 10 is formed on the first main surface 61 of the wiring body 5, but is not particularly limited thereto, and a functional layer such as a hard coat layer, an antistatic layer, an antiglare layer, an antifouling layer, an antireflection layer, a high dielectric layer, an adhesive layer, and an electromagnetic wave shielding layer, may be formed. Even in this case, the surface roughness of the first main surface 61 is relatively large, and thus, it is possible to improve an adhering force between the functional layer and the wiring body 5.

In the embodiment described above, the wiring body or the wiring board has been described as being used in the touch sensor, but is not particularly limited thereto. For example, the wiring body may be used as a heater by energizing the wiring body to generate heat according to resistance heating or the like. In this case, it is preferable that a carbon-based material having a high comparatively electrical resistance value is used as the conductive particles of the conductor portion. In addition, a part of the conductor portion of the wiring body is grounded, and thus, the wiring body may be used as an electromagnetic shielding shield. In addition, the wiring body may be used as an antenna. In this case, the mounting target on which the wiring body is mounted corresponds to an example of the "support body" in the present invention.

EXPLANATIONS OF LETTERS OR NUMERALS

| 1 | touch sensor |
|---|---|
| 2 | wiring board |
| 3 | substrate |
| 5 | wiring body |
| 6 | main body portion |
| 61 | first main surface |
| 7 | first layered portion |
| 71 | first resin portion |
| 711 | first flat portion |
| 711a | first upper surface |
| 712 | first protruding portion |
| 713 | first resin portion contact surface |
| 72 | first conductor portion |
| 73 | first conductor portion contact surface |
| 74 | first conductor portion top surface |

| | |
|---|---|
| 741 | first top surface flat portion |
| 75 | first conductor portion side surface |
| 751, 752 | end portion |
| 753 | first side surface flat portion |
| 76 | first conductor pattern |
| 77 | first electrode |
| 78 | first lead-out wiring |
| 79 | first terminal |
| 8 | second layered portion |
| 81 | second resin portion |
| 811 | second flat portion |
| 811a | second upper surface |
| 812 | second protruding portion |
| 82 | second conductor portion |
| 83 | second conductor portion contact surface |
| 84 | second conductor portion top surface |
| 841 | second top surface flat portion |
| 85 | second conductor portion side surface |
| 851, 852 | end portion |
| 853 | second side surface flat portion |
| 86 | second conductor pattern |
| 87 | second electrode |
| 88 | second lead-out wiring |
| 89 | second terminal |
| 9 | overcoat portion |
| 91 | second main surface |
| 10 | decorative portion |
| 11 | adhesive portion |
| 100 | first intaglio |
| 101 | first concave portion |
| 110 | first conductive material |
| 120 | first resin material |
| 130 | first substrate |
| 131 | third main surface |
| 140 | first intermediate |
| 150 | second intaglio |
| 151 | second concave portion |
| 160 | second conductive material |
| 170 | second resin material |
| 180 | second intermediate |
| 190 | third resin material |
| 200 | second substrate |
| 201 | fourth main surface |

**Claims**

1. A wiring body comprising:

   a main body portion including at least one layered portion which includes a resin portion, and a conductor portion disposed on the resin portion; and
   an overcoat portion disposed on the main body portion to cover the conductor portion,
   wherein surface roughness of a first main surface of the main body portion is relatively greater than surface roughness of a second main surface of the overcoat portion, the first main surface being on a side opposite to the overcoat portion, and the second main surface being on a side opposite to the main body portion.

2. The wiring body according to claim 1, wherein the surface roughness of the first main surface is 10 nm to 100 nm.

3. The wiring body according to claim 1 or 2, wherein the surface roughness of the second main surface is less than or equal to 5 nm.

4. The wiring body according to any one of claims 1 to 3, wherein the conductor portion is in a tapered shape in which the conductor portion is narrowed as being close to the overcoat portion.

5. The wiring body according to any one of claims 1 to 4, wherein the main body portion includes two layered portions,
   the resin portion of one layered portion is disposed to cover the conductor portion of other layered portion, and is interposed between the conductor portion of the one layered portion and the conductor portion of the other layered portion, and
   the overcoat portion covers the conductor portion of the one layered portion.

6. The wiring body according to any one of claims 1 to 5, wherein the conductor portion includes:

   a contact surface in contact with the resin portion; and
   a top surface on a side opposite to the contact surface,
   the contact surface is positioned on the same side as the first main surface with respect to the top surface,
   the top surface is positioned on the same side as the second main surface with respect to the contact surface, and
   surface roughness of the contact surface is relatively greater than surface roughness of the top surface.

7. The wiring body according to claim 6, wherein the surface roughness of the contact surface is relatively greater than the surface roughness of the first main surface, and
   the surface roughness of the top surface is relatively greater than the surface roughness of the second main surface.

8. A wiring board comprising;
   the wiring body according to any one of claims 1 to 7;
   a support body supporting the wiring body from a side of the first main surface; and

an adhesive portion interposed between the wiring body and the support body.

9.  A touch sensor comprising:

    the wiring board according to claim 8.

10. A manufacturing method of a wiring body comprising:

    a first step of curing a conductive material filling in a concave portion of an intaglio;
    a second step of pressing a first board against the intaglio through a first resin material;
    a third step of curing the first resin material;
    a fourth step of integrally releasing an intermediate containing the conductive material and the first resin material, and the first substrate from the intaglio;
    a fifth step of pressing a second substrate against the intermediate from a side opposite to the first substrate in the intermediate through a second resin material;
    a sixth step of curing the second resin material; and
    a seventh step of releasing the first substrate from the intermediate and of releasing the second substrate from the second resin material, wherein surface roughness of a third main surface of the first board is relatively greater than surface roughness of a fourth main surface of the second board, the third main surface being on a side facing the intermediate, the fourth main surface being on a side facing the second resin material.

FIG. 1

EP 3 438 799 A1

FIG. 2

FIG. 3

FIG. 4

EP 3 438 799 A1

FIG. 5

EP 3 438 799 A1

FIG. 6(A)    FIG. 6(B)    FIG. 6(C)

FIG. 6(D)    FIG. 6(E)

EP 3 438 799 A1

FIG. 7(A)

151  160

150

FIG. 7(B)

151  160

150

FIG. 7(C)

170

110(72)⎫
120(71)⎬140

130  131

FIG. 7(D)

130  131

120(72)⎫
110(71)⎬140

170
150

151  160(82)

FIG. 7(E)

130  131

140
170(81)⎫180
160(82)

151

150

FIG. 7(F)

190

160(82)
170(81)
110(72)⎫
120(71)⎬140 ⎫180

130  131

FIG. 7(G)

201  200  190

160(82)
170(81)⎫180
110(72)⎫
120(71)⎬140

130  131

FIG. 7(H)

91

82⎫9
81⎬8 ⎫5
72⎫7 ⎬6
71

61

**INTERNATIONAL SEARCH REPORT**

| International application No. |
| --- |
| PCT/JP2017/008330 |

**A. CLASSIFICATION OF SUBJECT MATTER**
*G06F3/041*(2006.01)i, *G06F3/044*(2006.01)i, *H05K1/02*(2006.01)i, *H05K3/38*
(2006.01)i

According to International Patent Classification (IPC) or to both national classification and IPC

**B. FIELDS SEARCHED**

Minimum documentation searched (classification system followed by classification symbols)
G06F3/041, G06F3/044, H05K1/02, H05K3/38

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 2009-251403 A (Asahi Kasei Corp.),<br>29 October 2009 (29.10.2009),<br>paragraphs [0012] to [9958]; fig. 1<br>(Family: none) | 1<br>4,6,8-9<br>2-3,5,7,10 |
| Y<br>A | JP 2010-109012 A (Dainippon Printing Co.,<br>Ltd.),<br>13 May 2010 (13.05.2010),<br>paragraphs [0010] to [0038]; fig. 4 to 5, 7<br>(Family: none) | 4,6,8-9<br>2-3,5,7,10 |

| ☐ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>27 March 2017 (27.03.17) | Date of mailing of the international search report<br>04 April 2017 (04.04.17) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016065920 A

- JP 2015108958 A